# EUROPEAN PATENT APPLICATION

(11) **EP 4 546 047 A1**
(43) Date of publication of application: **30.04.2025**
(21) Application number: 24206454.1
(22) Date of filing: 14.10.2024
(51) Int. Cl.: G03F 1/74, G03F 1/84, H01J 37/317

(54) **METHOD FOR PROCESSING A DEFECT OF A MICROLITHOGRAPHIC PHOTOMASK**

(30) Priority: 26.10.2023 DE 102023129605
(71) Applicant: Carl Zeiss SMT GmbH, 73447 Oberkochen (DE)
(72) Inventor: BUDACH, Michael, 64380 Roßdorf (DE)
(74) Representative: Horn Kleimann Waitzhofer Schmid-Dreyer Patent- und Rechtsanwälte PartG mbB

(57) **Abstract**

A method for processing a defect (D) of a microlithographic photomask (100) is disclosed, wherein a process gas is activated with the aid of a particle beam (802), wherein a control unit (828) is provided for controlling a deflection unit (816) with a control bandwidth (GF), wherein the deflection unit (816) for deflecting the particle beam (802) is configured to guide the particle beam (802) over the photomask (100), including the following steps:
a) providing (S1) an image (200') of at least a portion of the photomask (100),
b) ascertaining a repair shape (108, 500, 502, 1102, 1104, 1300-1304, 1400-1410, 1500-1508) in the image (200') on the basis of the control bandwidth (GF), wherein the repair shape (108, 500, 502, 1102, 1104, 1300-1304, 1400-1410, 1500-1508) comprises the defect (D), and
c) providing the particle beam (802) at m pixels (410) of the repair shape (108, 500, 502, 1102, 1104, 1300-1304, 1400-1410, 1500-1508) with the aid of the deflection unit (816), and activating the process gas for the purpose of processing the defect (D).

## Description

The present invention relates to a method for processing a defect of a microlithographic photomask, a computer program product and an apparatus.

The content of the priority application DE 10 2023 129 605.1 is incorporated by reference in its entirety.

Microlithography is used to produce microstructured component parts, for example integrated circuits. The microlithography process is carried out using a lithography apparatus comprising an illumination system and a projection system. The image of a photomask (reticle) illuminated by means of the illumination system is in this case projected by means of the projection system onto a substrate, for example a silicon wafer, which is coated with a light-sensitive layer (photoresist) and arranged in the image plane of the projection system, in order to transfer the mask structure to the light-sensitive coating of the substrate.

To obtain smaller structure sizes, and hence an increase in the integration density of the microstructured components, use is increasingly made of light at very short wavelengths, which is referred to as deep ultraviolet (DUV) or extreme ultraviolet (EUV), for example. DUV has a wavelength of 193 nm, for example, and EUV has a wavelength of 13.5 nm, for example.

In this case, the microlithographic photomasks even have structure dimensions ranging from a few nanometres to several 100 nm. The production of such photomasks is very complicated and therefore costly. In particular, this is the case because the photomasks have to be defect-free as it is otherwise not possible to ensure that a structure produced on the silicon wafer by means of the photomask exhibits the desired function. In particular, the quality of the structures on the photomask is decisive for the quality of the integrated circuits produced on the wafer by means of the photomask.

It is for this reason that microlithographic photomasks are checked for the presence of defects and found defects are repaired in a targeted manner. Typical defects include the lack of envisaged structures, for example because an etching process was not carried out successfully, or else the presence of non-envisaged structures, for example because an etching process proceeded too quickly or developed its effect at a wrong site. These defects can be remedied by targeted etching of excess material or targeted deposition of additional material at the appropriate positions; for example, this is possible in a very targeted manner by means of electron beam-induced processes (FEBIP, "focussed electron beam induced processing").

DE 10 2017 208 114 A1 describes a method for particle beam-induced etching of a photolithographic mask. In this case, a particle beam, in particular an electron beam, and an etching gas are provided at a site on the photolithographic mask to be etched. The particle beam activates a local chemical reaction between a material of the photolithographic mask and the etching gas, as a result of which material is locally ablated from the photolithographic mask.

Against this background, a problem addressed by the present invention is that of providing an improved method and an improved apparatus for processing a defect of a microlithographic photomask.

According to a first aspect, a method for processing a defect of a microlithographic photomask is provided, wherein a process gas is activated with the aid of a particle beam, wherein a control unit is provided for controlling a deflection unit with a control bandwidth, wherein the deflection unit for deflecting the particle beam is configured to guide the particle beam over the photomask, including the following steps:
a) providing an image of at least a portion of the photomask,
b) ascertaining a repair shape in the image on the basis of the control bandwidth, wherein the repair shape comprises the defect, and
c) providing the particle beam at m pixels of the repair shape with the aid of the deflection unit, and activating the process gas for the purpose of processing the defect.

Taking account of the control bandwidth when ascertaining the repair shape allows the settling behaviour of the particle beam on the target pixel to be taken into account. As a result, improved edge shapes, in particular an improved edge steepness or an improved edge profile, can be obtained, especially when repairing defects.

The processing of the defect comprises, in particular, an etching of the defect, within the scope of which material is locally ablated from the photomask, or a deposition of material on the photomask in the region of the defect. By way of example, the proposed method allows a superfluous structure in the region of the defect to be better etched away, or a missing structure in the region of the defect to be better augmented.

The repair shape comprises the defect, i.e. the repair shape contains the defect.

The image of the at least one portion of the photomask is recorded by means of a scanning electron microscope (SEM), for example. By way of example, the image of the at least one portion of the photomask has a spatial resolution of the order of a few nanometres. The image may also be recorded using a scanning probe microscope (SPM), such as, e.g., an atomic force microscope (AFM) or a scanning tunnelling microscope (STM).

The method may in particular include a step of capturing the image of the at least one portion of the photomask by means of a scanning electron microscope and/or a scanning probe microscope.

For example, the microlithographic photomask is a photomask for an EUV lithography apparatus. In this case, EUV stands for "extreme ultraviolet" and denotes a wavelength of the working light of between 0.1 nm and 30 nm, in particular 13.5 nm. Within an EUV lithography apparatus, a beam shaping and illumination system is used to guide EUV radiation onto a photomask (also referred to as "reticle"), which in particular is in the form of a reflective optical element (reflective photomask). The photomask has a structure which is imaged onto a wafer or the like in a reduced fashion by means of a projection system of the EUV lithography apparatus.

For example, the microlithographic photomask can also be a photomask for a DUV lithography apparatus. In this case DUV stands for "deep ultraviolet" and denotes a wavelength of the working light of between 30 nm and 250 nm, in particular 193 nm or 248 nm. Within a DUV lithography apparatus, a beam shaping and illumination system is used to guide DUV radiation onto a photomask, which in particular is in the form of a transmissive optical element (transmissive photomask). The photomask has a structure which is imaged onto a wafer or the like in a reduced fashion by means of a projection system of the DUV lithography apparatus.

For example, the microlithographic photomask comprises a substrate and a structure formed on the substrate by way of a coating. For example, the photomask is a transmissive photomask, in the case of which the pattern to be imaged is realized in the form of an absorbing (i.e. opaque or partly opaque) coating on a transparent substrate. Alternatively, the photomask can also be a reflective photomask, for example, especially for use in EUV lithography. Binary or phase-shifting photomasks are considered in embodiments.

For example, the substrate comprises silicon dioxide (SiO2), e.g. fused quartz. For example, the structured coating comprises chromium, chromium compounds, tantalum compounds and/or compounds made of silicon, nitrogen, oxygen and/or molybdenum. The substrate and/or the coating may also comprise other materials.

In the case of a photomask for an EUV lithography apparatus, the substrate may comprise an alternating sequence of molybdenum and silicon layers.

Using the proposed method, it is possible to identify, locate and repair a defect of a photomask, in particular a defect of a structured coating of the photomask. In particular, a defect is an (e.g. absorbing or reflecting) coating of the photomask that has been applied incorrectly to the substrate. The method can be used to augment the coating at sites on the photomask where it is lacking. Furthermore, the coating can be removed using the method from sites on the photomask where it has been applied incorrectly.

To this end, a geometric shape of the defect is determined in the recorded image of the at least one portion of the photomask. By way of example, a two-dimensional, geometric shape of the defect is determined. The determined geometric shape of the defect is referred to below as a so-called repair shape.

m pixels are defined in the repair shape for the particle beam-induced processing of said repair shape. Over the course of the method, the particle beam is directed at each of the m pixels of the repair shape. In particular, an intensity maximum of the electron beam is directed at each centre of each of the m pixels. In other words, the m pixels of the repair shape represent a raster, in particular a two-dimensional raster, of the repair shape for the particle beam-induced processing. For example, the m pixels of the repair shape correspond to areas of incidence of the particle beam during the particle beam-induced processing of the defect. For example, a pixel dimension is chosen in such a way that an intensity distribution of an electron beam that is directed at a centre of a pixel drops to a predetermined intensity at the edge of the pixel on account of the electron beam's Gaussian intensity distribution. The predetermined intensity may correspond to a drop to half of the intensity maximum or else a drop to any other fraction of the intensity maximum of the electron beam. For example, a pixel dimension and/or an electron beam full width at half maximum is in the subnanometre range or of the order of a few nanometres.

For example, the process gas is a precursor gas and/or an etching gas. For example, the process gas can be a mixture of a plurality of gaseous components, i.e. a process gas mixture. For example, the process gas can be a mixture of a plurality of gaseous components, of which each only has a certain molecule type.

In particular, alkyl compounds of main group elements, metals or transition elements can be considered as precursor gases suitable for the deposition or for growing of elevated structures. Examples thereof are (cyclopentadienyl)trimethylplatinum (CpPtMes Me = CH₄), (methylcyclopentadienyl)trimethylplatinum (MeCpPtMes), tetramethyltin (SnMe₄), trimethylgallium (GaMes), ferrocene (Cp₂Fe), bis-arylchromium (Ar₂Cr), and/or carbonyl compounds of main group elements, metals or transition elements, such as, for example, chromium hexacarbonyl (Cr(CO)s), molybdenum hexacarbonyl (Mo(CO)s), tungsten hexacarbonyl (W(CO)s), dicobalt octacarbonyl (Co₂(CO)₈), triruthenium dodecacarbonyl (Ru₃(CO)₁₂), iron pentacarbonyl (Fe(CO)₅), and/or alkoxide compounds of main group elements, metals or transition elements, such as, for example, tetraethyl orthosilicate (Si(OC₂H₅)₄), tetraisopropoxytitanium (Ti(OC₃H₇)₄), and/or halide compounds of main group elements, metals or transition elements, such as, for example, tungsten hexafluoride (WF₆), tungsten hexachloride (WCls), titanium tetrachloride (TiCl₄), boron trifluoride (BF₃), silicon tetrachloride (SiCl₄), and/or complexes comprising main group elements, metals or transition elements, such as, for example, copper bis(hexafluoroacetylacetonate) (Cu(C₅F₆HO₂)₂), dimethylgold trifluoroacetylacetonate (Me₂Au(C₅F₃H₄O₂)), and/or organic compounds such as carbon monoxide (CO), carbon dioxide (CO₂), aliphatic and/or aromatic hydrocarbons, and the like.

For example, the etching gas may comprise: xenon difluoride (XeF₂), xenon dichloride (XeCl₂), xenon tetrachloride (XeCl₄), steam (H₂O), heavy water (D₂O), oxygen (O₂), ozone (Os), ammonia (NH₃), nitrosyl chloride (NOCl) and/or one of the following halide compounds: XNO, XONO₂, X₂O, XO₂, X₂O₂, X₂O₄, X₂O₆, where X is a halide. Further etching gases for etching one or more of the deposited test structures are specified in the applicant's US patent application having the number 13/0 103 281.

The process gas may comprise further additional gases, for example oxidizing gases such as hydrogen peroxide (H₂O₂), nitrous oxide (N₂O), nitrogen oxide (NO), nitrogen dioxide (NO₂), nitric acid (HNOs) and other oxygen-containing gases, and/or halides such as chlorine (Cl₂), hydrogen chloride (HCl), hydrogen fluoride (HF), iodine (I₂), hydrogen iodide (HI), bromine (Br₂), hydrogen bromide (HBr), phosphorus trichloride (PCl₃), phosphorus pentachloride (PCl₅), phosphorus trifluoride (PF₃) and other halogen-containing gases, and/or reducing gases, such as hydrogen (H₂), ammonia (NH₃), methane (CH₄) and other hydrogen-containing gases. These additional gases can be used, for example, for etching processes, as buffer gases, as passivating media and the like.

For example, the activating particle beam is provided with the aid of an apparatus which may comprise: a particle beam source for creating the particle beam; a particle beam guiding device (e.g. scanning unit) configured to direct the particle beam at a respective pixel of the repair shape, of a plurality of repair shapes or of the respective repair sub-shape of the photomask; a particle beam shaping device (e.g. electron or beam optics) configured to shape, in particular focus, the particle beam; at least one storage container configured to store the process gas or at least one gaseous component of the process gas; at least one gas provision device configured to provide the process gas or the at least one gaseous component of the process gas with a predetermined gas quantity flow rate to the respective pixel of the repair shape, of a plurality of repair shapes or of the respective repair sub-shape.

The activating particle beam for example comprises an electron beam, an ion beam and/or a laser beam.

For example, an electron beam is provided with the aid of a modified scanning electron microscope. For example, the image of the at least one portion of the photomask is recorded using the same modified scanning electron microscope that provides the activating electron beam.

The activating particle beam activates, in particular, a local chemical reaction between a material of the photomask and the process gas, which leads locally to a deposition of material on the photomask from the gas phase or to a transition of material of the photomask into the gas phase.

The activating particle beam is successively provided at each of the pixels of the repair shape, of a plurality of repair shapes or of the respective repair sub-shape, for example by means of the particle beam guiding device (in particular the deflection unit). In step c) of the method, the activating particle beam remains on each of the pixels for predetermined dwell time. For example, the dwell time is 100 ns.

The repair shape can comprise the defect in whole or in part. The repair shape may have: a reniform, U-shaped or ring-shaped shape. In the present case, "repair shape" might also refer to a repair sub-shape, providing nothing else is specified to the contrary.

For example, the number "m" and/or "n" (see below) is greater than 100, 1000, 10 000, 100 000 or 1 000 000 in each case.

According to an embodiment, the control bandwidth is ascertained or provided before step a), in particular before or when a particle beam column is put into operation for the purpose of carrying out steps a) to c), wherein by preference the ascertained or provided control bandwidth or a value derived therefrom is stored in a data memory before step b) and used in step b).

The control bandwidth or the value derived therefrom can be stored in a computer program in particular, said computer program being worked through within the scope of the above-described method.

According to a further embodiment, step b) includes:
b1) subdividing the repair shape comprising the defect into a number k of repair sub-shapes on the basis of the control bandwidth, and selecting one of the k repair sub-shapes, and/or
b2) subdividing the repair shape comprising the defect into a number k of repair sub-shapes and selecting one of the k repair sub-shapes, wherein the selection is implemented on the basis of the control bandwidth,
wherein step c) includes:
providing the particle beam at m pixels of the selected k repair sub-shapes with the aid of the deflection unit, and activating the process gas for the purpose of processing the defect.

Thus, the control bandwidth can be considered already during the subdivision of the repair shape or only during the selection of the respective repair sub-shape, in particular when determining the sequence of repair sub-shapes as swept over by the particle beam in temporal succession. According to a variant, both the subdivision and the selection can be implemented on the basis of the control bandwidth. "k" can be greater than or equal to 2, 10 or 100.

According to a further embodiment, the ascertainment according to step b) or the subdivision according to step b1) and/or the selection according to step b2) is implemented on the basis of a spacing or a jump width between two repair shapes or between two of the k repair sub-shapes.

The greater the spacing or the jump width, the longer the particle beam generally takes to reach a settled state again. Accordingly, it is particularly advantageous to link this information with the control bandwidth.

According to a further embodiment, step c) includes:
providing the particle beam at m pixels of a first repair shape or of a first of the k repair sub-shapes with the aid of the deflection unit, and activating the process gas for the purpose of processing the defect,
providing the particle beam at n pixels of a second repair shape or of a second of the k repair sub-shapes with the aid of the deflection unit, and activating the process gas for the purpose of processing the defect.

In particular, each of the k repair sub-shapes can be swept over or raster scanned by the particle beam more than 100 or more than 1000 times before there is a switch to the next repair shape, which is then in turn also swept over more than 100 or more than 1000 times by the particle beam. The particle beam can be deactivated or raster scanned between repetitions in order to allow process gas to flow into the respective repair sub-shape.

According to a further embodiment, a first pixel and/or a last pixel of the n or m pixels is selected in randomized fashion.

This avoids unwanted patterns on the photomask.

According to a further embodiment, the k repair sub-shapes are each formed without interruption in the scanning direction of the particle beam.

As a result, these can be scanned quickly and without jump effects (settling of the particle beam).

According to a further embodiment, a sweep line method is used in step b1) or b2).

This mathematical method allows a simple and efficient division of a repair shape into a plurality of repair sub-shapes, which are each convex and/or at least embodied without an interruption (i.e. without a cutout) in the scanning direction. Accordingly, the particle beam need not overcome a gap, a cutout or the like. This avoids jumps or settling effects.

According to a further embodiment, the repair shape comprises a cutout, the size dimension of which is between 5 nm and less than 10 µm.

According to a further embodiment, a spacing between two pixels within the repair shape or a respective one of the k repair sub-shapes is less than 40, 20 or 5 nm.

According to a further embodiment, the deflection unit comprises a multipole, in particular an octupole, for beam deflection purposes.

Other means for beam deflection, for example capacitor plates or magnetic coils, can be used instead of the multipole or octupole.

According to a further embodiment, in step c), the particle beam is moved along a straight line and/or moved along parallel lines or lines perpendicular thereto.

According to a further embodiment, in step c), the particle beam is moved parallel to the longest edge and/or one of the k repair sub-shapes.

Unwanted jumps of the particle beam can be avoided as a result, or an effective sweep of the repair shape or repair sub-shape by the particle beam is obtained thus.

According to a further embodiment, in step b), a first repair shape comprising the defect and a second repair shape are ascertained, wherein the second repair shape is located at least partially within the first repair shape.

Advantageously, what is known as a biasing effect can be obtained as a result; this can likewise take account of the settling behaviour of the particle beam at the target position (target pixel).

According to a further embodiment, a contour of the second repair shape is partly recessed in relation to the contour of the first repair shape.

According to a further embodiment, the second repair shape in part has the same contour as the first repair shape.

Depending on the jump pixel or target pixel of the particle beam, it may be necessary to offset the contour vis-à-vis the first repair shape - or not, as the case may be.

According to a further embodiment, when the first and the second repair shape are overlaid between two adjacent contours of the first and second repair shape, one or more pixels are located along a straight line which intersects the two adjacent contours.

According to a second aspect, a computer program product is provided. The latter comprises instructions which, when executed by an apparatus for processing a defect of a photomask for a lithography apparatus, prompt the apparatus to carry out the above-described method steps.

A computer program product, for example a computer program medium, can be provided or supplied, for example, as a storage medium, for example a memory card, a USB stick, a CD-ROM, a DVD, or else in the form of a downloadable file from a server in a network. For example, in a wireless communications network, this can be effected by transferring an appropriate file with the computer program product or the computer program means.

According to a third aspect, an apparatus is provided for processing a defect of a microlithographic photomask. The apparatus comprises:
a process gas provision device for providing a process gas,
a particle source for providing a particle beam,
a deflection unit for deflecting the particle beam in order to provide the particle beam at m pixels of a repair shape and activate the process gas,
a control unit for controlling the deflection unit with a control bandwidth,
a detector unit for providing an image of at least a portion of the photomask, and
an ascertainment unit for ascertaining the repair shape in the image on the basis of the control bandwidth, wherein the repair shape comprises the defect. Each of the units mentioned above and below, e.g. the computing apparatus, the control unit or the ascertainment unit, can be implemented in hardware and/or software. In the case of an implementation as hardware, the corresponding unit can be embodied as an apparatus or as part of an apparatus, for example as a computer or as a microprocessor. For example, the apparatus may comprise a central processing unit (CPU), a graphical processing unit (GPU), a programmable hardware logic (e.g. a field-programmable gate array, FPGA), an application-specific integrated circuit (ASIC) or the like. Moreover, the one or more units may be implemented together in a single hardware apparatus, and they can for example share a memory, interfaces and the like. The units can also be realized in separate hardware components.

"A(n)" should not necessarily be understood as a restriction to exactly one element in the present case. Rather, a plurality of elements, for example two, three or more, may also be provided. Nor should any other numeral used here be understood to the effect that there is a restriction to exactly the stated number of elements. Rather, unless indicated otherwise, numerical deviations upwards and downwards are possible.

Further possible implementations of the invention also encompass not explicitly mentioned combinations of features or embodiments that are described above or hereinafter with respect to the exemplary embodiments. In this case, a person skilled in the art will also add individual aspects as improvements or supplementations to the respective basic form of the invention.

Further advantageous configurations and aspects of the invention are the subject matter of the dependent claims and also of the exemplary embodiments of the invention that are described below. The invention is explained in detail hereinafter on the basis of preferred embodiments with reference to the accompanying figures.
Fig. 1 schematically shows a detail of a microlithographic photomask having a defect in a structured coating according to one embodiment;
Fig. 2 shows a detail of a photomask having firstly a healthy structure and secondly a defect, according to one embodiment;
Fig. 3 shows an enlarged view of the defect from Fig. 2;
Fig. 4 shows a plurality of three exemplary scanning methods;
Fig. 5 schematically shows a repair shape of a defect with two repair sub-shapes;
Fig. 6 shows the position of the electron beam as a function of time in one exemplary embodiment;
Fig. 7 contrasts two edge geometries created with different control bandwidths;
Fig. 8 shows an apparatus for processing a defect of a photomask according to one exemplary embodiment;
Fig. 9 schematically shows a functional interaction of a few components from Fig. 8;
Fig. 9A shows an amplitude of a control signal as a function of frequency according to one exemplary embodiment;
Fig. 10 shows an exemplary embodiment of a method in a flowchart;
Figs 11 and 12 show annular repair shapes according to various exemplary embodiments;
Fig. 13 shows repair sub-shapes with different spacings from one another in the scanning direction according to one exemplary embodiment;
Fig. 14 shows repair sub-shapes arranged in a two-dimensional grid, according to one exemplary embodiment;
Fig. 15 shows the repair shape from Fig. 5 subdivided into five repair sub-shapes, according to one exemplary embodiment;
Figs 16 to 20 show repair shapes with different geometries according to various exemplary embodiments;
Fig. 21 shows the view from Fig. 1 with a suitably chosen scanning direction for repairing defects according to one exemplary embodiment;
Fig. 22 shows the view from Fig. 5, wherein scanning is carried out according to a method with a biasing effect;
Fig. 23 shows a recessed contour in one repair sub-shape;
Fig. 24 shows an enlarged view of Fig. 23; and
Fig. 25 shows two recessed contours in one repair sub-shape.

Unless indicated otherwise, elements that are identical or functionally identical have been provided with the same reference signs in the figures. Furthermore, it should be noted that the illustrations in the figures are not necessarily true to scale.

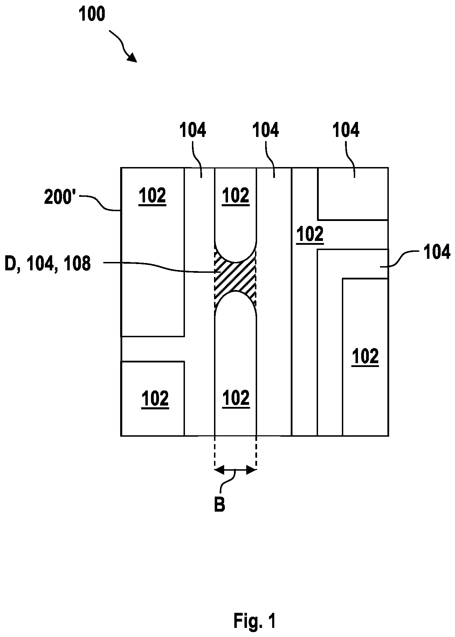

Fig. 1 schematically shows a detail of a microlithographic photomask 100. In the example shown, the photomask 100 is a transmissive photolithographic mask 100. The photomask 100 comprises a substrate 102. The substrate 102 is optically transparent, especially at the wavelength with which the photomask 100 is exposed. By way of example, a material of the substrate 100 comprises fused quartz.

A structured coating 104 (pattern elements 104) has been applied to the substrate 102. In particular, the coating 104 is a coating made of an absorbing material. For example, a material of the coating 104 comprises a chromium layer. For example, a thickness of the coating 104 ranges from 50 nm to 100 nm. A structure dimension B of the structure formed by the coating 104 on the substrate 102 of the photomask 100 may differ at various positions of the photomask 100. For example, the width B of a region is plotted as structure dimension in Fig. 1. For example, the structure dimension B lies in a range from 20 to 200 nm. The structure dimension B may also be greater than 200 nm, for example be of the order of micrometres.

Other materials to those mentioned may also be used for the substrate and the coating in other examples. Furthermore, the photomask 100 can also be a reflective photomask rather than a transmissive photomask. In this case, a reflecting layer is applied instead of an absorbing layer 104.

Occasionally, defects D can arise during the production of photomasks, for example because etching processes do not run exactly as intended. In Fig. 1, such a defect D is represented by hatching. This is excess material since the coating 104 was not removed from this region even though the two coating regions 104 next to one another are envisaged as separate in the template for the photomask 100. One could also say that the defect D forms a connecting piece. In this case, a dimension of the defect D corresponds to the structure dimension B. Other defects which are smaller than the structure dimension B, for example in a range of 5 to 20 nm, are also known. To ensure that a structure produced in a lithography apparatus using the photomask has the desired shape on a wafer and hence the semiconductor component produced in this way fulfils the desired function, it is necessary to repair defects, such as the defect D shown in Fig. 1 or else other defects. In this example it is necessary to remove the connecting piece in a targeted manner, for example by particle beam-induced etching.

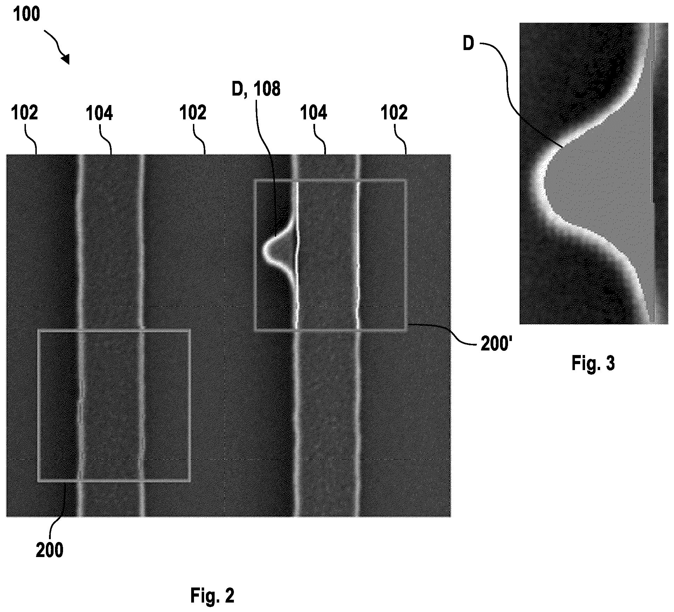

Figs 2 to 4 are used to illustrate a possible procedure for repairing a defect D shown in Fig. 2. A "healthy" region is denoted by 200 to the left of Fig. 2. That is to say, the coating 104 or the substrate 102 corresponds to the target specifications in this region. The healthy image detail 200 is subsequently copied and placed above the defect D, as elucidated by reference sign 200'. Fig. 3 shows the defect D in an enlarged view. The latter is formed by a convex excess of material in this exemplary embodiment. The material requiring removal becomes clear by the superimposition of the healthy material region 200.

In the case of electron beam-based mask repair, the region D is now scanned several thousand times using the electron beam in order to remove the defect. It is initially irrelevant here whether this relates to a so-called clear defect or opaque defect.

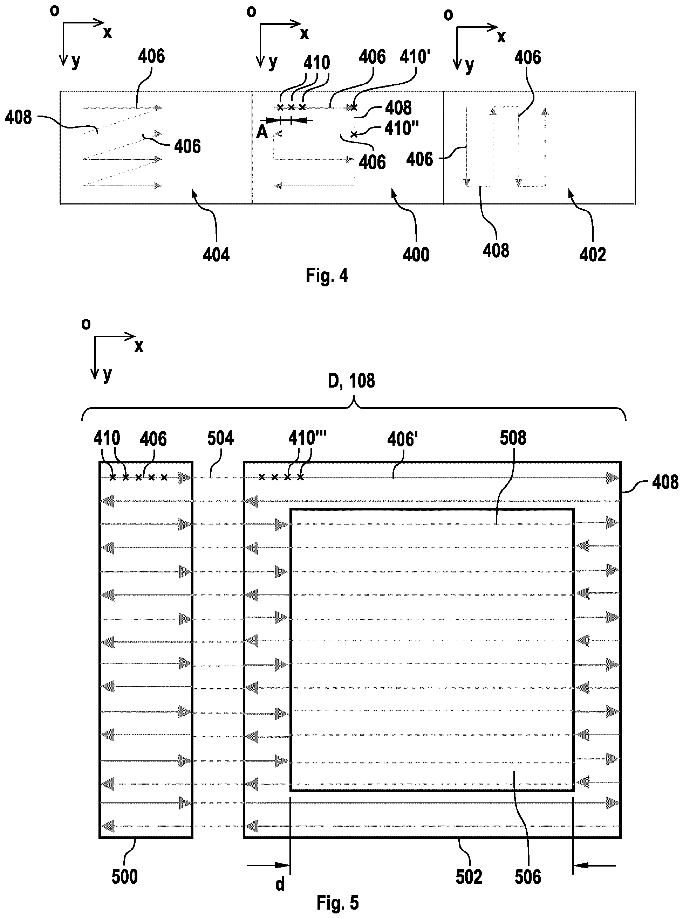

Fig. 4 shows various scan variants for moving the electron beam over the defect D in order thereby to accordingly etch away the coating 104 under activation of a process gas (or in order to deposit material from the process gas for repair purposes in other variants). For example, the patterns shown in Fig. 4 are traversed or raster scanned between 100 and 1 000 000 times, until the corresponding defect has been ablated or deposited.

In Fig. 4, a serpentine x-scan is denoted by 400, a serpentine y-scan is denoted by 402 and a raster scan is denoted by 404. Starting with the serpentine x-scan 400 centrally in Fig. 4, a solid line 406 (referred to as "scan line" below) therein denotes a row of pixels 410 which are successively scanned or raster scanned. The particle beam is offset in the y-direction (referred to as "jump" 408 below) at the end of the respective scan line 406. Thereupon, the particle beam is moved in the negative x-direction in a manner parallel to the previous scan line 406, before a further jump 408 is scheduled.

The scan in the x-direction can just as easily be implemented in the y-direction, with the result that pixels here are scanned in the y-direction and the jump is implemented in the x-direction. This is shown to the right in Fig. 4 (serpentine y-scan 402). What is known as a raster scan 404 is shown to the left in Fig. 4. In this case, there is a diagonal return jump at the end of a respective scan line 406, with the result that the start is back at x = 0 (origin O).

The pixels 410 correspond to the image points in the image detail 200' from Fig. 2. Each pixel 410 corresponds to a location on the photomask 100. There, the electron beam is incident on the process gas, whereby an etching or deposition process is triggered at this location. The pixels for example have a spacing of less than 40, 20 or 5 nm. In Fig. 4, the spacing is shown for two adjacent pixels 410 by way of example and denoted by A therein.

In the region of the scan lines 406, the electron beam is moved at a defined speed, and individual pixels 410 are addressed in the process, i.e. the electron beam dwells on a respective pixel 410 for a defined period of time ("dwell time"). The electron beam is moved as quickly as possible in the region of a respective jump 408. For example, the dwell time can be between 10 and 500 nanoseconds. At the end of the dwell time, the electron beam is moved to the next pixel, wherein the intermediate region between the two adjacent pixels 410 within the spacing A is swept over. The electron beam is not deactivated in the intermediate region. However, on account of the only very short exposure time in the intermediate region, the electron beam does not develop any noticeable effect. Thus it is not deactivated at the first pixel at the end of the dwell time, moved to the next pixel, and reactivated there.

The same is true for the jump 408. The last pixel of the scan line 406 has been denoted using reference sign 410' by way of example. The first pixel of the next scan line 406 has been denoted using 410". The electron beam is moved as quickly as possible between pixels 410' and 410". It is not, for instance, deactivated at the end of the dwell time at pixel 410' and reactivated at the next pixel 410".

The jump between two adjacent pixels 410 is characterized in that the scanning direction (positive x-direction in this case) is maintained. By contrast, the jump between pixels 410, 410' in different scan lines 406 is characterized in that there is a change from one scanning direction (positive x-direction in this case) to another, optionally opposite scanning direction (negative x-direction in this case). Between two repair shapes 500, 502 (see below), there is a jump from one repair (sub-)shape to another.

Fig. 5 shows a defect D and the assigned repair shape 108, which was ascertained from the image detail 200'. With the aid of a computer device and an appropriate algorithm, the repair shape 108 is decomposed into for example two repair sub-shapes (portions) 500, 502. The repair sub-shapes, by way of example a rectangle 500 and a rectangular ring 502 in this case, are spaced apart from one another in the scanning direction x. Accordingly, this yields a first scan line 406 within the repair sub-region 500, subsequently a jump 504 and, following this, a further scan line 406' within the repair sub-shape 502. Since a serpentine x-scan 400 is performed here by way of example, the electron beam is offset in the y-direction at the end of the scan line 406', whereby the jump 408 arises. Subsequently, the electron beam is displaced back in the direction of the origin O in a manner parallel to the scan line 406.

The repair sub-shape 502 comprises a cutout 506. This is the region enclosed by the ring 502. For example, the cutout 506 can have a width d of at least 500 nm and less than 10 µm in the scanning direction x. Accordingly there is a further jump 508 of the electron beam within the repair shape 502.

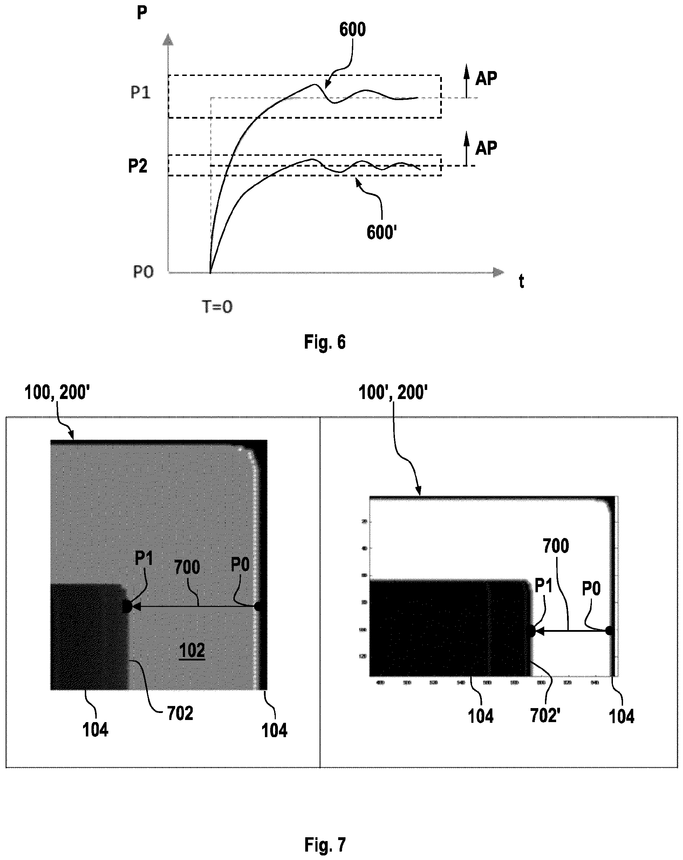

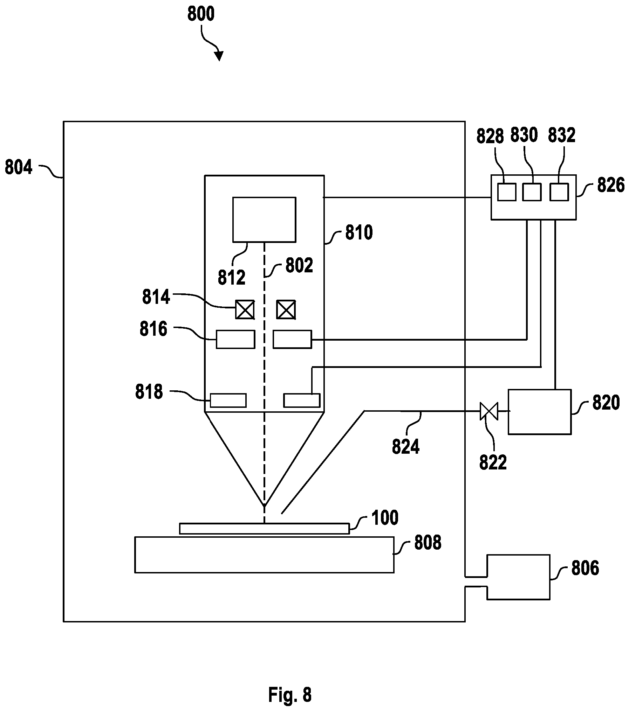

Fig. 6 shows a diagram in which the time t is plotted on the abscissa, and the jump width P is plotted on the ordinate. As mentioned, the electron beam is moved as quickly as possible in the region of a jump 408, 504, 506. To this end, the electron beam is initially accelerated strongly proceeding from the position P0 (first pixel) and then decelerated strongly in turn towards the position P1 (next pixel). In the case of an electron beam column, the electron beam is deflected from the position P0 towards the position P1 by means of a deflection unit (shown in Fig. 8).

For instance, the deflection unit is in octupole (or other multipole) at the lower end of the electron beam column. The octupole comprises a plurality of coils or electrodes which create electric or magnetic fields for beam deflection purposes. In other embodiments, one or more capacitors, in particular capacitor plates, could be used instead of an octupole. The deflection unit is controlled by a control unit (shown in Fig. 8). As a result of the control unit having a finite control bandwidth, the electron beam must initially settle at the end of the movement (settling curve 600), i.e. at the position P1.

If the jump width is shorter, as illustrated for the point P2 in Fig. 6, then an amplitude AP of the settling curve 600' is smaller than the amplitude AP of the settling curve 600. This initially means that there is a different dose distribution (electron dose) at the target point P1 or P2 of a jump 408, 504, 506 vis-à-vis the initial point P0. What also emerges is that, for the same control bandwidth, the electron dose following a jump can be concentrated better at a point in the case of a smaller jump width (see position P2). The same applies if the control bandwidth is increased and the jump width remains unchanged.

Fig. 7 illustrates a plan view of a partial detail of a photomask 100 to the left. In the region shown, the photomask 100 comprises two coatings 104 which are spaced apart from one another by means of an exposed region 102 in which the substrate is visible. In the exemplary embodiment, the electron beam jumps from the point P0 to the point P1. The dwell time at the point P0 (corresponding to a last pixel of a scan line not shown) is for example 20 ns, just like at the point P1 (first pixel of a scan line not shown). The control bandwidth is 5 MHz.

The edge 702 of the structure 104 is smeared on account of the settling curve 600 (see Fig. 6). The correspondingly flat increase in the dose distribution has a negative effect on the edge steepness (the so-called side wall angle) of the edge repair. The problem of the settling behaviour does not arise at the jump point, and so a sharp edge is present here; this likewise emerges from the image to the left in Fig. 7.

A photomask 100' is shown on the right-hand side of Fig. 7. In this case, the structure corresponds to that of the illustration on the left-hand side. However, the electron beam column used to process the photomask 100' has a higher control bandwidth, specifically 100 MHz. Accordingly, the settling curve (cf. 600' in Fig. 6) has a smaller amplitude AP. This leads to a greater edge steepness in comparison with the illustration on the left-hand side. Accordingly, the edge 702' has a sharp embodiment in the illustration on the right-hand side of Fig. 7.

Fig. 8 shows an apparatus 800 for particle beam-induced processing of a defect D of a microlithographic photomask 100, for example the defect D of the photomask 100 from Figs 1, 2 ,3 , 5 and 7. For example, the apparatus 800 is a repair tool for photomasks 100 for a DUV or EUV lithography apparatus.

Fig. 8 shows schematically the section through a few components of the apparatus 800 which can be used for particle beam-induced repairing, in this case etching, of the defect D of the photomask 100. Moreover, the apparatus 800 can also be used for imaging the photomask, in particular the structured coating 104 of the mask 100 and of the defect D before, during and after the implementation of a repair process.

The apparatus 800 shown in Fig. 8 represents a modified scanning electron microscope 800. In this case, a particle beam in the form of an electron beam 802 is used to repair the defect D. The use of an electron beam 802 as activating particle beam has the advantage that the electron beam 802 substantially cannot damage, or can only slightly damage, the photomask 100, in particular the substrate 102 thereof.

A laser beam for activating a local particle beam-induced repair process for the photomask 100 can be used instead of the electron beam 802 or in addition to the electron beam 802 in embodiments (not shown in Fig. 8). Further, instead of an electron beam and/or a laser beam, it is possible to use an ion beam, an atom beam and/or a molecule beam for activating a local chemical reaction (not shown in Fig. 8).

The apparatus 800 is largely arranged in a vacuum housing 804, which is kept at a certain gas pressure by a vacuum pump 806.

A photomask 100 to be processed is arranged on a sample stage 808. By way of example, the sample stage 808 is configured to set the position of the photomask 100 in three spatial directions and in three axes of rotation with an accuracy of a few nanometres.

The apparatus 800 comprises an electron column 810. The electron column 810 comprises an electron source 812 for providing the activating electron beam 802. Furthermore, the electron column 810 comprises electron or beam optics 814. The electron source 812 produces the electron beam 802 and the electron or beam optics 814 focus the electron beam 802 and direct the latter to the photomask 100 at the output of the column 810. The electron column 810 moreover comprises a deflection unit 816 (scanning unit 816) which is configured to guide, i.e. raster scan or scan, the electron beam 802 over the surface of the photomask 100.

The apparatus 800 furthermore comprises a detector 818 for detecting the secondary electrons and/or backscattered electrons created at the photomask 800 by the incident electron beam 802. For instance, as shown, the detector 818 is arranged around the electron beam 802 in ring-shaped fashion within the electron column 810. As an alternative and/or in addition to the detector 818, the apparatus 800 may also comprise other/further detectors for detecting secondary electrons and/or backscattered electrons (not shown in Fig. 8).

Moreover, the apparatus 800 may comprise one or more scanning probe microscopes, for example scanning force microscopes, which can be used to analyse the defect D of the photomask 100 (not shown in Fig. 8).

The apparatus 800 furthermore comprises a gas provision device 820 for supplying process gas to the surface of the photomask 100. For example, the gas provision device 820 comprises a valve 822 and a gas line 824. The electron beam 802 directed at a location on the surface of the photomask 100 by the electron column 810 can carry out electron-beam induced processing (EBIP) in conjunction with the process gas supplied by the gas provision device 820 from outside via the valve 222 and the gas line 824. In particular, said process comprises a deposition and/or an etching of material.

The apparatus 800 moreover comprises a computing apparatus 826, for example a computer, having a control unit 828, an ascertainment unit 830 and a memory unit 832. In the example of Fig. 8, the computing apparatus 826 is arranged outside of the vacuum housing 804.

In particular, the computing apparatus 826 controls the provision of the electron beam 802 by controlling the electron column 810. In particular, the control unit 828 controls the raster scanning of the electron beam 802 over the surface of the photomask 100 by controlling the deflection unit 816. Moreover, the computing apparatus 826 controls the provision of the process gas by controlling the gas provision device 820.

Moreover, the computing apparatus 826 receives measured data from the detector 818 and/or other detectors of the apparatus 800 and creates images from the measured data, which images can be displayed on a monitor (not shown). Moreover, images created from the measured data can be stored in a memory unit 832 of the computing apparatus 826.

To check the photomask 100 and, in particular, the structured coating 104 of the photomask 100, the apparatus 800 is configured, in particular, to capture an image of the photomask 100 (Fig. 1) or an image 200' of a detail of the photomask 100 from measured data from the detector 818 and/or other detectors of the apparatus 800. By way of example, a spatial resolution of the image 300 is of the order of a few nanometres.

The computing apparatus 826, in particular the ascertainment unit 830, is configured to recognize a defect D (Fig. 1) in the recorded image 200', to locate said defect and to ascertain a geometric shape (repair shape 108) of the defect D. For example, the ascertained repair shape 108 is a two-dimensional geometric shape.

The computing apparatus 826, in particular the ascertainment unit 830, is configured to arrange the repair shape 108 in a grid comprising a number m of pixels 410 (see Fig. 4). For example, the repair shape 108 comprises 1 million pixels 304 (m = 1 000 000). For example, the pixels 304 have a size of 1.5 nm x 1.5 nm. Over the course of the repair method, the electron beam 802 is directed at each centre of each pixel 410 multiple times by means of the deflection unit 816. In particular, an intensity maximum of the Gaussian intensity profile of the electron beam 802 is directed at each centre of each pixel 410 multiple times over the course of the method.

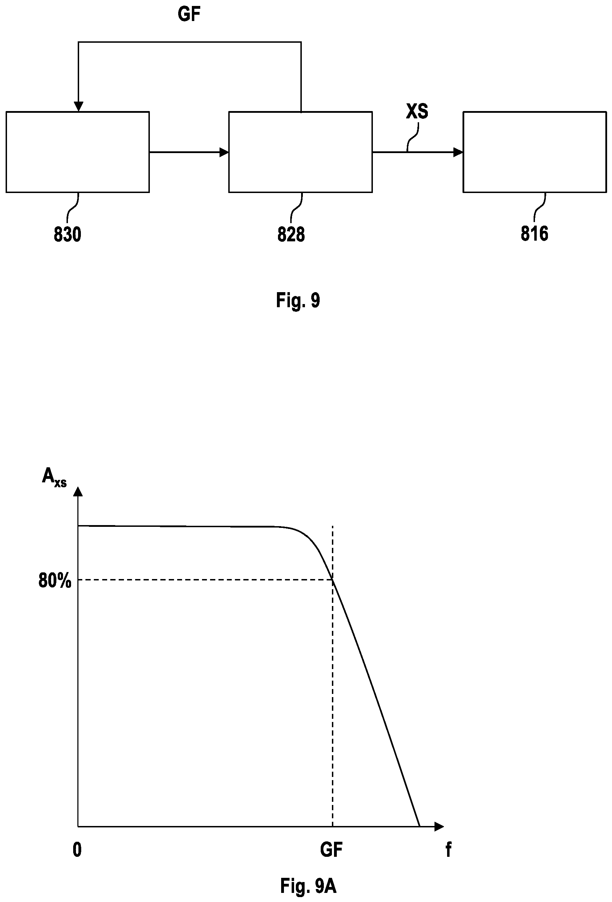

Fig. 9 schematically shows a few components from Fig. 8. The control unit 828 creates a control signal XS which it uses to control the deflection unit 816. Fig. 9A shows an amplitude A_{XS} of the control signal XS as a function of frequency f. The control unit 828 can be considered to be a low-pass filter. The latter passes signals at a frequency up to the limit frequency GF - referred to as control bandwidth in the present case - substantially without change. By contrast, the output signal XS of the control unit 828 is attenuated significantly above the limit frequency GF.

Thus, accordingly, the control signal XS is composed of frequency components below the control bandwidth GF. The control signal XS is preferably analogue. The control unit 828 itself can have an analogue or digital embodiment. In particular it receives a digital signal from the ascertainment unit 830, and this digital signal is converted into an analogue signal within the control unit 828.

For example, the function depicted in Fig. 9A can be ascertained by virtue of examining the control signal XS in respect of its frequency components. For example, the control bandwidth GF can be defined as the frequency f at which the amplitude Axs drops below a value of 80% of the maximum amplitude Axs, as plotted by way of example in Fig. 9A. The control bandwidth GF is provided to the ascertainment unit 830.

In one variant, the control bandwidth GF is read from the control unit 828 following a calibration of the apparatus 800 or during the operation of the apparatus 800, i.e. while raster scanning the pixels 410. As a result, it is possible to respond to changes in the control bandwidth by the ascertainment unit 830.

In another variant, the control signal XS is measured after the apparatus 800 has been put into operation and calibrated, and the control bandwidth GF is ascertained, more particularly calculated, from the measured data. The control bandwidth GF defined thus is stored in the data memory 832 (see Fig. 8), for example. In particular, the control bandwidth GF can be stored as part of a computer program executed on the computer apparatus 826. In particular, the computer program can be part of the ascertainment unit 830. In the ascertainment unit 830, the control bandwidth GF is used to ascertain the repair shape 108 having the defect D on the basis of said control bandwidth.

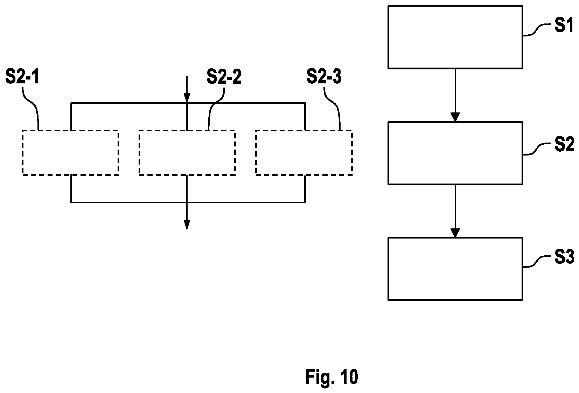

In general, the corresponding method is depicted in Fig. 10. In a step S1, an image of at least a portion of the photomask 100 is recorded with the aid of the apparatus 800 and provided thereby. In particular, recording is implemented with the aid of the detector unit 818.

In a step S2, the repair shape 108 is ascertained in the image 200', to be precise in a manner depending on the control bandwidth GF. The repair shape 108 comprises the defect D, to be precise at least in part or in full. How the repair shape 108 is ascertained in detail is yet to be explained in detail below. It is significant that the ascertainment need not be implemented in a manner directly dependent on the control bandwidth GF. In particular, it is also possible to use a value derived from the control bandwidth GF. As already described for the control bandwidth GF, this value can be read from the control unit 828 and/or be provided in the memory unit 832, optionally as part of the aforementioned computer program. Such an indirect use of the control bandwidth GF is also encompassed in the present case.

In the step S3, the particle beam 802 is provided at m pixels 410 of the repair shape 108 with the aid of the deflection unit 816, and said particle beam activates a process gas there in order to thereby process, more particularly etch or deposit, the defect as a result.

Step S2 can be designed such that it implements one or more of the variants S2-1 to S2-3, which are depicted to the left in Fig. 10. In this context, one of the variants S2-1 to S2-3 can be implemented in the apparatus 800, or else a plurality of the variants can be implemented, wherein one of the variants S2-2 to S2-3 is selected optionally in automated fashion, depending on the application.

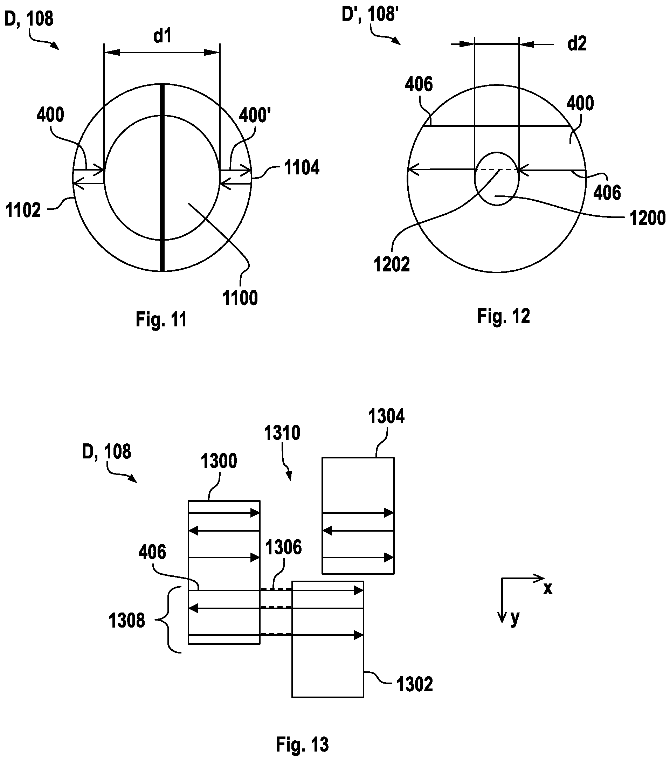

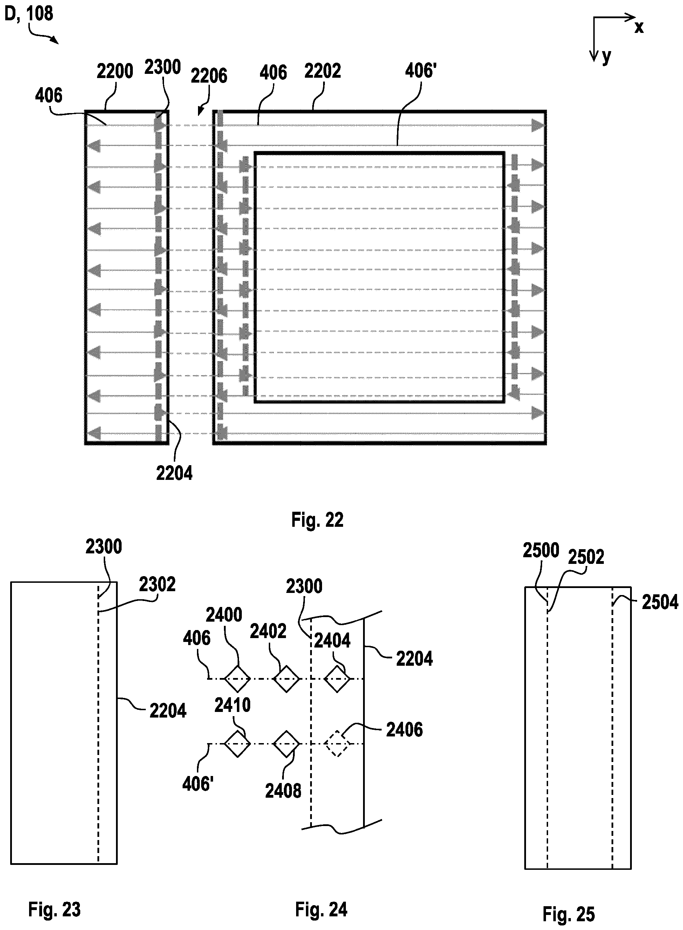

The variants S2-1 and S2-2 are explained in detail below on the basis of Figs 13 to 15 in particular. With regards to the variant S2-3, reference is made to Figs 22 to 25.

A possible implementation of method step S2-1 is explained on the basis of Figs 11 and 12. Figs 11 and 12 each show an annular defect D or a corresponding repair shape 108, 108'. These comprise a cutout 1100 and 1200, respectively, in which no pixels should be scanned, or this region remains untouched by processing by means of the electron beam 802. The diameter of the cutout 1100 is denoted by d1, that of the cutout 1200 by d2. For a diameter d1, i.e. the repair shape 108, the ascertainment unit 830 now establishes that the corresponding jump width would be too large, and hence this would not lead to acceptable edges. This is in view of the determined control bandwidth GF. Accordingly, it subdivides the repair shape 108 into two semicircular repair shapes 1102, 1104, which are subsequently scanned by means of separate serpentine scans 400, 400'.

In contrast thereto, in view of the control bandwidth GF and the diameter d2 which is smaller in comparison with the diameter d1, the ascertainment unit 830 assesses the defect D or the repair shape 108' to the effect that the repair shape 108' can be scanned as a whole, i.e. using a serpentine x-scan. Accordingly, the scan line 406 has a jump 1202 in the region of the cutout 1200.

Fig. 13 shows - for the purpose of explaining step S2-2 - a repair shape 108 of a defect D which is subdivided into for example three repair sub-shapes 1300, 1302 and 1304 with the aid of the ascertainment unit 830. For example, the ascertainment unit 830 can make a decision to the effect that the jump width 1306 in the scanning direction x is still acceptable in view of the control bandwidth GF, and so one scan line 406 is used to scan both the repair shape 1300 and the repair shape 1302 over a portion 1308 in the y-direction (i.e. transversely to the scanning direction x).

This is not true for the repair shape 1304; in this case, the ascertainment unit 830 establishes that the jump width 1310 would be too large in view of the control bandwidth GF. Accordingly, the repair shape 1304 is scanned separately, only after or before the repair shape 1300, 1302 has been scanned.

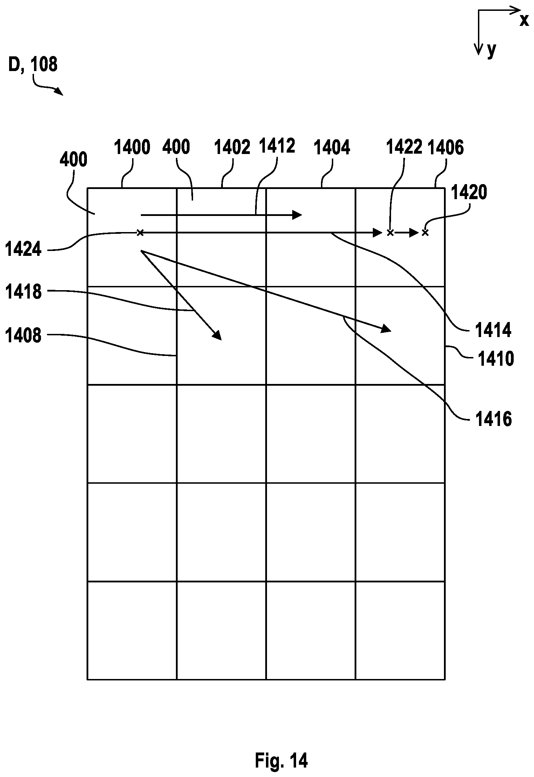

Fig. 14 illustrates a rectangular defect D or a rectangular repair shape 108. For example, the latter is once again subdivided into rectangular repair shapes, which form a grid in the x- and y-directions. By way of example, a few of the repair shapes have been labelled 1400 to 1410. The subdivision into repair shapes 1400 to 1410, i.e. the size of a respective rectangle, can for example be determined in such a way that a process gas atmosphere is maintained to a sufficient extent for etching or deposition during the raster scan of the pixels (not shown) of a respective rectangle 1400 to 1410. This cannot always be ensured if the repair shapes are too large.

The repair shapes 1400 to 1410 are scanned independently in each case, and so these are each assigned a serpentine scan 400. For a respective repair shape 1400 to 1410, the serpentine scan 400 can be repeated a few thousand times, for example, until there is a change to the respective next repair shape 1400 to 1410. This change is indicated in Fig. 14 by jumps 1412, 1414, 1416 and 1418. These jumps, or the decision with regard to the repair shape jumped to next, are decided by the ascertainment unit 830 in view of the control bandwidth GF. In light of the control bandwidth GF, individual jumps may be found to be too far here with regards to producing a sufficient edge steepness. For example, the control unit 830 might decide that jump 1414 or 1416 is too far but jumps 1412 and 1418 are acceptable. As illustrated for jump 1414 by way of example, there might also be a decision here that a jump to a pixel 1420 would be too far but a jump to the pixel 1422 is still acceptable.

The ascertainment unit 830 may further be configured to select the jump pixel, illustrated here by pixel 1424 by way of example, and/or the target pixel 1422 from the pixels contained in the repair shape 1400 or 1406 in randomized fashion. This prevents repeating (unwanted) patterns, which are determined by otherwise unchanging jump and target positions, from arising on the photomask 100.

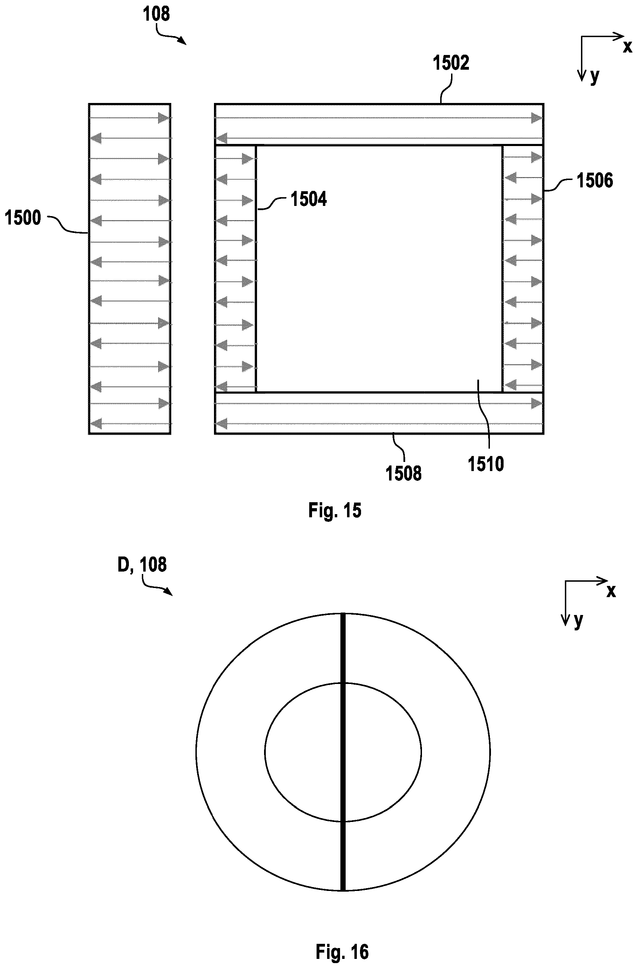

Fig. 15 illustrates an exemplary embodiment with a repair shape 108 corresponding to that from Fig. 5. However, a subdivision into five repair sub-shapes 1500, 1502, 1504, 1506, 1508 has been implemented here. This has been carried out in such a way that admissible jumps are performed at all times given the control bandwidth GF.

Otherwise, it should be observed that a repair shape 108 that is admissible in view of the control bandwidth GF can already be found by virtue of changing the scanning direction from x to y. This makes no difference in the case of the cutout 1510 formed with the same dimensions in the x- and y-directions. However, if the cutout 1510 were to have a large width in the x-direction and a narrow depth in the y-direction, a change of the scanning direction from x to y would lead to no admissible jump widths being present anymore.

Figs 16 to 20 illustrate various options for subdividing repair shapes 108 in such a way that a jump width that is admissible in view of the control bandwidth GF is observed, or that jumps are avoided entirely.

For example, the annular segment 108 in Fig. 16 is subdivided into two semicircular ring segments by the ascertainment unit 830.

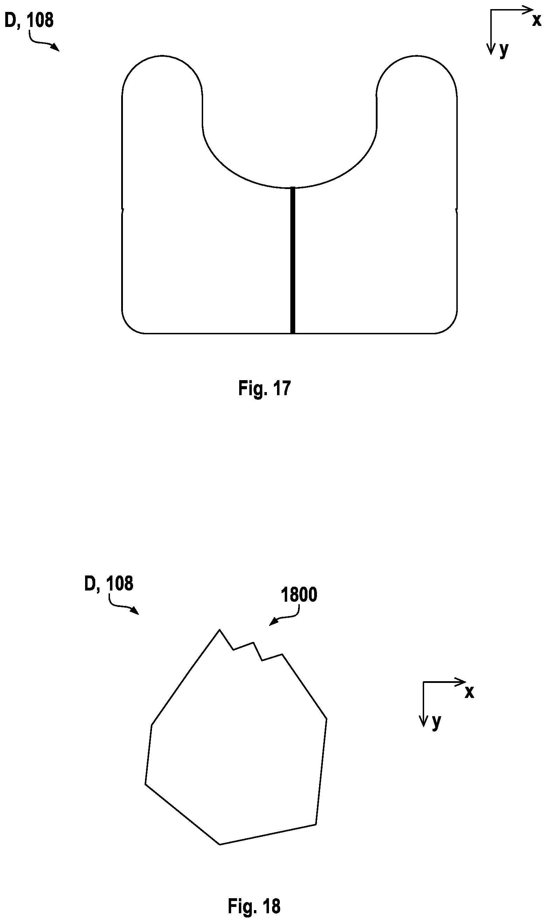

The reniform shape 108 in Fig. 17 is also subdivided into two admissible repair shapes by the ascertainment unit 830.

With regards to the jagged edge region 1800 of the repair shape 108 in Fig. 18, the ascertainment unit 108 establishes that this repair shape can be scanned without a jump by way of a serpentine x-scan.

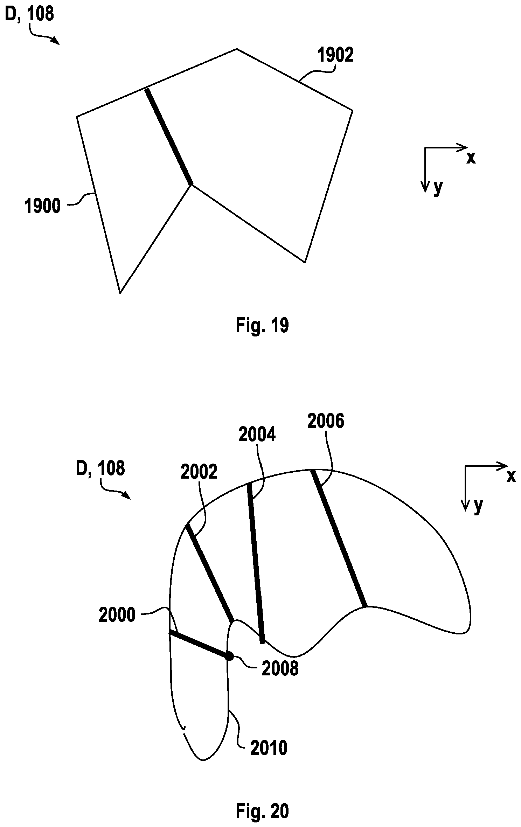

With regards to Fig. 19, the ascertainment unit 830 subdivides the repair shape 108 into two repair shapes, specifically into two polygons, a quadrilateral 1900 and a pentagon 1902 in this case.

The repair shape 108 of Fig. 20, which is likewise reniform in portions, is subdivided into five repair shapes in order to be able to traverse the latter without a jump using a serpentine x-scan. The separation lines 2000, 2002, 2004 and 2006 plotted in the process are in each case directed to reversal points (one of which has been denoted by reference sign 2008 by way of example) of an outer encompassing line 2010 of the repair shape 108.

A sweep line method can be used in each case to subdivide the repair shape 108 into repair sub-shapes as described in the figures above.

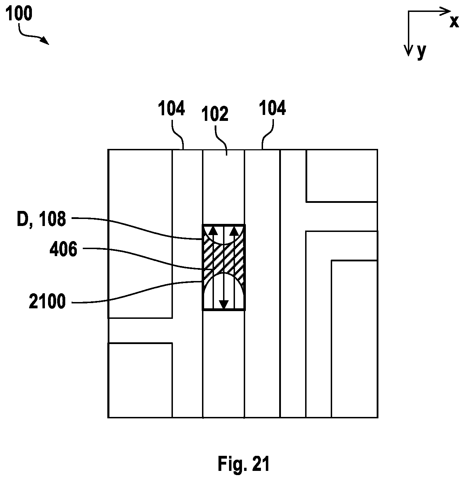

Fig. 21 illustrates the aforementioned aspect whereby the scanning direction is chosen on the basis of the control bandwidth GF. The reference sign 2100 denotes a longest edge of the repair shape 108. In the case of the repair shape 108 depicted in Fig. 21, jumps would arise in the case of a scan in the x-direction. By contrast, if the scan is carried out in the y-direction (i.e. parallel to the longest edge 2100), as illustrated by the scan lines 406, then each jump is avoided. However, such a rotation might for example only be implemented once the ascertainment unit 830 has established this as necessary in light of the control bandwidth GF. Thus, if the jump widths in the scanning direction x are small, it is possible to manage without a change of the scanning direction in the y-direction (this also comprises a rotation of the photomask 100 through 90°).

Fig. 22 once again illustrates the repair shape 108 already known from Fig. 5. This repair shape 108 was subdivided into a rectangle 2200 and into a rectangular ring 2202 (frame). All pixels corresponding with the defect D that are to be scanned are located therein.

Now, to implement step S2-3 (see Fig. 10), a repair shape 2300 is selected within the repair shape 2200 (see Fig. 23). It comprises a contour 2300 which is recessed vis-à-vis the (right) edge 2204. The edge 2204 of the repair shape 2200 adjoins the gap 2206 that is to be bridged within the scope of a serpentine x-scan. The corresponding gap 2206 thus corresponds to a corresponding jump of the electron beam 802 that allows a continuation of the scan line 406 in the repair sub-region 2202.

Fig. 24 shows a portion from Fig. 23 in the region of the edge 2204 in enlarged fashion. The electron beam 802 successively scans pixels 2400, 2402 and 2404 in the scanning direction x. The electron beam jumps at pixel 2404 and continues its path on the scan line 406 in the region 2202. This is acceptable for the repair process since jumping is not associated with smearing or a settling behaviour. If the electron beam travels in the opposite direction, i.e. in the negative x-direction - see scan line 406' in region 2202 - then the electron beam jumps there and lands in the repair sub-region 2200. In principle, it would land on pixel 2406 in the case of an unchanging scan pattern. However, this would lead to an unintended edge flatness on account of the settling behaviour. Accordingly, the second repair shape 2300 is recessed vis-à-vis the first repair shape 2200 in such a way that the electron beam arrives not at pixel 2406 but at pixel 2408 following its jump over the gap 2206; this is also referred to as "biasing" in the present case.

Accordingly, a repair shape 2500 with recessed contours 2502 and 2504, as shown in Fig. 25, can also be ascertained for the repair sub-shape 2202, and so the settling behaviour of the electron beam 802 in view of the control bandwidth GF is taken into consideration there in each case.

Although the present invention has been described on the basis of exemplary embodiments, it can be modified in various ways.

### LIST OF REFERENCE SIGNS

- 100: Photomask
- 102: Substrate
- 104: Coating
- 108: Repair shape
- 108': Repair shape
- 200: Healthy image detail
- 200': Image detail with a defect
- 400: Serpentine x-scan
- 400': Serpentine x-scan
- 402: Serpentine y-scan
- 404: Raster scan
- 406: Scan line
- 406': Scan line
- 408: Jump
- 410: Pixel
- 410': Pixel
- 410": Pixel
- 410‴: Pixel
- 500: Repair sub-shape
- 502: Repair sub-shape
- 504: Jump
- 600: Settling curve
- 600': Settling curve
- 700: Jump
- 702: Edge
- 702': Edge
- 800: Apparatus
- 802: Electron beam
- 804: Vacuum housing
- 806: Vacuum pump
- 808: Sample stage
- 810: Electron column
- 812: Electron source
- 814: Electron optics
- 816: Deflection unit
- 818: Detector unit
- 820: Gas provision unit
- 822: Valve
- 824: Gas line
- 826: Computer apparatus
- 828: Control unit
- 830: Ascertainment unit
- 832: Memory unit
- 1100: Cutout
- 1102: Repair sub-shape
- 1104: Repair sub-shape
- 1200: Cutout
- 1202: Jump
- 1300: Repair sub-shape
- 1302: Repair sub-shape
- 1304: Repair sub-shape
- 1306: Jump
- 1308: Overlap
- 1310: Gap
- 1400: Repair sub-shape
- 1402: Repair sub-shape
- 1404: Repair sub-shape
- 1406: Repair sub-shape
- 1408: Repair sub-shape
- 1410: Repair sub-shape
- 1412: Jump
- 1413: Jump
- 1414: Jump
- 1416: Jump
- 1418: Jump
- 1420: Pixel
- 1422: Pixel
- 1424: Pixel
- 1500: Repair sub-shape
- 1502: Repair sub-shape
- 1504: Repair sub-shape
- 1506: Repair sub-shape
- 1508: Repair sub-shape
- 1510: Cutout
- 1800: Edge region
- 1900: Repair sub-shape
- 1902: Repair sub-shape
- 2000: Separation line
- 2002: Separation line
- 2004: Separation line
- 2006: Separation line
- 2008: Reversal point
- 2010: Contour
- 2100: Longest edge
- 2200: Repair sub-shape
- 2202: Repair sub-shape
- 2204: Edge
- 2300: Repair sub-shape
- 2302: Contour
- 2400: Pixel
- 2402: Pixel
- 2404: Pixel
- 2406: Virtual pixel
- 2408: Pixel
- 2410: Pixel
- 2500: Repair sub-shape
- 2502: Contour
- 2504: Contour

- A: Spacing
- AP: Amplitude
- Axs: Amplitude
- B: Structure width
- d: Width
- d1: Diameter
- d2: Diameter
- D: Defect
- f: Frequency
- GF: Control bandwidth
- O: Origin
- P: Position
- P0: Position
- P1: Position
- P2: Position
- S1-S3: Method steps
- T: Time
- x: Scanning direction
- XS: Control signal
- y: Scanning direction

## Claims

1. Method for processing a defect (D) of a microlithographic photomask (100), wherein a process gas is activated with the aid of a particle beam (802), wherein a control unit (828) is provided for controlling a deflection unit (816) with a control bandwidth (GF), wherein the deflection unit (816) for deflecting the particle beam (802) is configured to guide the particle beam (802) over the photomask (100), including the following steps:
a) providing (S1) an image (200') of at least a portion of the photomask (100),
b) ascertaining a repair shape (108, 500, 502, 1102, 1104, 1300-1304, 1400-1410, 1500-1508) in the image (200') on the basis of the control bandwidth (GF), wherein the repair shape (108, 500, 502, 1102, 1104, 1300-1304, 1400-1410, 1500-1508) comprises the defect (D), and
c) providing the particle beam (802) at m pixels (410) of the repair shape (108, 500, 502, 1102, 1104, 1300-1304, 1400-1410, 1500-1508) with the aid of the deflection unit (816), and activating the process gas for the purpose of processing the defect (D).

2. Method according to Claim 1, wherein the control bandwidth (GF) is ascertained or provided before step a), in particular before or when a particle beam column (810) is put into operation for the purpose of carrying out steps a) to c), wherein by preference the ascertained or provided control bandwidth (GF) or a value derived therefrom is stored in a data memory (832) before step b) and used in step b).

3. Method according to Claim 1 or 2, wherein step b) includes:
b1) subdividing (S2-1) the repair shape (108) comprising the defect (D) into a number k of repair sub-shapes (1102, 1104) on the basis of the control bandwidth (GF), and selecting one of the k repair sub-shapes (1102, 1104), and/or
b2) subdividing (S2-2) the repair shape (108) comprising the defect (D) into a number k of repair sub-shapes (1300-1304, 1400-1410) and selecting one of the k repair sub-shapes (1300-1304, 1400-1410), wherein the selection is implemented on the basis of the control bandwidth (GF),
wherein step c) includes:
providing the particle beam (802) at m pixels (410) of the selected k repair sub-shapes (1300-1304, 1400-1410) with the aid of the deflection unit (816), and activating the process gas for the purpose of processing the defect (D).

4. Method according to any of Claims 1 to 3, wherein the ascertainment according to step b) or the subdivision according to step b1) and/or the selection according to step b2) is implemented on the basis of a spacing or a jump width (d1, d2, 1202, 1306, 1310, 1412-1418) between two repair shapes (108, 2200, 2002, 2300, 2500) or between two of the k repair sub-shapes (1300-1304, 1400-1410).

5. Method according to any of Claims 1 to 4, wherein step c) includes:
providing the particle beam (802) at m pixels (410) of a first repair shape (2200, 2202) or of a first of the k repair sub-shapes (500) with the aid of the deflection unit (816), and activating the process gas for the purpose of processing the defect (D),
providing the particle beam (802) at n pixels (410‴) of a second repair shape (2300, 2500) or of a second of the k repair sub-shapes (502) with the aid of the deflection unit (816), and activating the process gas for the purpose of processing the defect.

6. Method according to any of Claims 1 to 5, wherein a first pixel (1422) and/or a last pixel (1424) of the m or n pixels is selected in randomized fashion.

7. Method according to any of Claims 3 to 6, wherein the k repair sub-shapes (1102, 1104, 1300-1304, 1400-1410) are each formed without interruption in the scanning direction (x) of the particle beam (802).

8. Method according to any of Claims 3 to 7, wherein a sweep line method is used in step b1) or b2).

9. Method according to any of Claims 1 to 8, wherein the repair shape (108) comprises a cutout (506, 1100, 1200, 1510), the largest dimension (d, d1, d2) of which is between at least 5 nm and less than 10 µm.

10. Method according to any of Claims 1 to 9, wherein a spacing (A) between two pixels (410) within the repair shape (108) or a respective one of the k repair sub-shapes (500, 502, 1102, 1104, 1300-1304, 1400-1410, 1500-1508) is <40, 20 or 5 nm.

11. Method according to any of Claims 1 to 10, wherein the deflection unit (816) comprises an octupole for beam deflection purposes.

12. Method according to any of Claims 1 to 11, wherein, in step c), the particle beam (802) is moved along a straight line (406, 406') and/or moved along parallel lines and/or lines (406, 406') perpendicular thereto.

13. Method according to any of Claims 1 to 12, wherein, in step c), the particle beam (802) is moved parallel to the longest edge (2100) of the repair shape (108) and/or of one of the k repair sub-shapes (500, 502, 1102, 1104, 1300-1304, 1400-1410, 1500-1508).

14. Computer program product comprising instructions which, when executed by an apparatus (800) for processing a defect (D) of a microlithographic photomask (100), prompt the apparatus (800) to carry out the method steps (S1-S3) according to any of Claims 1 to 13.

15. Apparatus (800) for processing a defect (D) of a microlithographic photomask (100), comprising:
a process gas provision device (820) for providing a process gas,
a particle source (812) for providing a particle beam (802),
a deflection unit (816) for deflecting the particle beam (802) in order to provide the particle beam (802) at m pixels (410) of a repair shape (108, 500, 502, 1102, 1104, 1300-1304, 1400-1410, 1500-1508) and activate the process gas,
a control unit (828) for controlling the deflection unit (816) with a control bandwidth (GF),
a detector unit (818) for providing an image (200') of at least a portion of the photomask (100),
an ascertainment unit (830) for ascertaining the repair shape (108, 500, 502, 1102, 1104, 1300-1304, 1400-1410, 1500-1508) in the image (200') on the basis of the control bandwidth (GF), wherein the repair shape (108, 500, 502, 1102, 1104, 1300-1304, 1400-1410, 1500-1508) comprises the defect (D).
